**Europäisches Patentamt**

**European Patent Office**

**Office européen des brevets**

(19)

(11) Veröffentlichungsnummer: **0 205 807**
**B1**

# EUROPÄISCHE PATENTSCHRIFT

(12)

(45) Veröffentlichungstag der Patentschrift:
23.11.89

(21) Anmeldenummer: 86105474.0

(22) Anmeldetag: 21.04.86

(51) Int. Cl.⁴: **H03K 17/64**, H01F 7/18,
F01L 9/04

(54) Verfahren und Vorrichtung zum Betreiben eines elektromagnetischen Gaswechselventils.

(30) Priorität: 25.04.85 DE 3515042

(43) Veröffentlichungstag der Anmeldung:
30.12.86 Patentblatt 86/52

(45) Bekanntmachung des Hinweises auf die Patenterteilung:
23.11.89 Patentblatt 89/47

(84) Benannte Vertragsstaaten:
DE FR GB IT SE

(56) Entgegenhaltungen:
DE-A- 2 102 595
DE-A- 2 251 472
DE-A- 3 024 109
US-A- 3 946 285

(73) Patentinhaber: Klöckner, Wolfgang, Dr.,
Georg-Schuster-Strasse 16, D-8033 Krailling(DE)

(72) Erfinder: Büchl, Josef, Rehstelg 12, D-8071 Lenting(DE)

(74) Vertreter: Wuesthoff, Franz, Dr.-Ing. et al, Patentanwälte
Wuesthoff -v. Pechmann-Behrens-Goetz
Schweigerstrasse 2, D-8000 München 90(DE)

## Beschreibung

Die Erfindung betrifft ein Verfahren zum Betrieb einer Brennkraftmaschine gemäß Obergriff des Anspruchs 1. Weiterhin wird erfindungsgemäß eine Brennkraftmaschine gemäß Obergriff des Anspruchs 4 beschrieben.

Eine derartige Brennkraftmaschine ist der DE-A 30 24 109 entnehmbar. Die dort beschriebene Brennkraftmaschine besitzt Gaswechselventile, die nicht über eine Nockenwelle gesteuert werden, sondern in ihrer Öffnungs- und Schließlage durch ein Federsystem gedrückt werden. In Ruhestellung der Gaswechselventile ist das Gaswechselventil durch die Federbeaufschlagung in einem Ruhepunkt, der in etwa der Zwischenstellung zwischen Öffnungs- und Schließstellung entspricht. In den Endstellungen wird das Gaswechselventil durch Elektromagnete gehalten, wobei eine Ankerplatte des Gaswechselventiles an den Polflächen der Elektromagnete klebt. Mit Ausschalten eines Elektromagneten wird das Gaswechselventil durch die Federkraft beschleunigt in Richtung zum anderen Elektromagneten, um dort nach Auftreffen der Ankerplatte auf die Polfläche bei eingeschaltetem Elektromagneten kleben zu bleiben.

Der primäre Einschaltvorgang, um das Gaswechselventil aus seiner Ruhelage mittig zwischen den Öffnungs- und Schließelektromagneten zu bringen, geschieht durch eine Startansteuerung, die auf mechanischem, elektromagnetischem oder hydraulischem Wege das Gaswechselventil erstmalig in die Nähe des erregten Magneten drückt, damit das Federsystem vorgespannt wird, um anschließend die Energie aufbringen zu können, das Gaswechselventil in seiner Öffnungs- und Schließstellung hin- und herzudrücken.

Es leuchtet unmittelbar ein, daß eine derartige Vorrichtung nicht betriebsfähig ist, wenn das Gaswechselventil nicht in seine Öffnungs- und Schließstellung bewegt wird. Kommt es während des Betriebes zu einem Fehlverhalten, beispielsweise indem einer der Elektromagneten die Ankerplatte nicht richtig einfängt, so daß das Gaswechselventil in seine Ruhestellung übergeht, arbeitet das Gaswechselventil trotz weiterer Erregungen der Öffnungs- und Schließelektromagneten nicht mehr.

Aufgabe der Erfindung ist es, ein Verfahren anzugeben, um eine Brennkraftmaschine der gattungsgemäßen Art zu betreiben, ohne daß die oben beschriebenen Ausfälle auftreten.

Die Aufgabe wird gelöst durch die im Anspruch 1 angegebenen Merkmale.

Eine zur Durchführung des Verfahrens aufgebaute Brennkraftmaschine ist in Anspruch 4 beschrieben.

Erfindungsgemäß ist vorgesehen, daß durch Überwachung des Ansteuerstromes für die Elektromagnete eine Auftrefferkennung durchgeführt wird, so daß ein Überwachungssystem feststellen kann, ob die Elektromagnete die Ankerplatte auch tatsächlich angezogen haben. Wird durch dieses Überwachungssystem ein Fehlverhalten signalisiert, wird die Startvorrichtung angesteuert, um sofort das Gaswechselventil aus seiner mittigen Ruhestellung wieder in die Startstellung zu bringen, so daß es seinen Betrieb wieder aufnehmen kann.

Eine Auftrefferkennung der hier benutzten Art ist bekannt aus der DE-A 22 51 472, die dort für Blockierschutzsysteme angewendet wird. Die elektromagnetische Ansteuerung von elektromagnetischen Verbrauchern, wie sie hier bei den Elektromagneten zum Halten der Gaswechselventile durchgeführt wird, ist in der DE-A 28 28 678 beschrieben.

Gegenüber diesem Stand der Technik ist für die Erfindung wesentlich, daß sie eine sofortige Wiederaufnahme des Betriebes des Gaswechselventiles ermöglicht, so daß es zu keinen längeren Ausfällen und somit gefährlichen Betriebszuständen der Brennkraftmaschine kommen kann.

Im folgenden wird die Erfindung anhand der Figuren deutlicher dargestellt. Es zeigen

Fig. 1 den Stromverlauf abhängig von der Zeit beim Einschalten des elektromagnetischen Verbrauchers mit auf den Prüfflächen des Elektromagneten auftreffendem Anker; und

Fig. 2 das Signal, das aus der Differenzierung des Stromverlaufes nach Fig. 1 gewonnen wird.

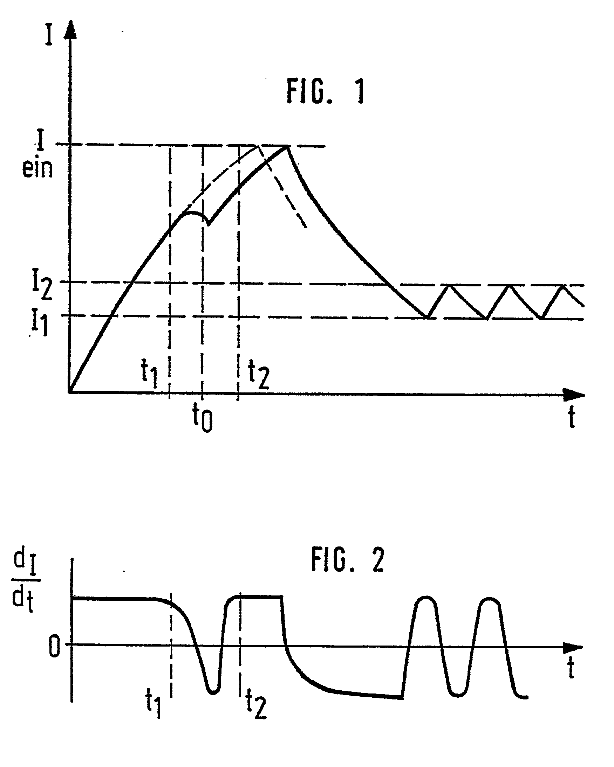

In Fig. 1 ist der zeitliche Verlauf des Einschaltstromes für einen Elektromagneten eines Gaswechselventiles dargestellt. Der Elektromagnet besteht aus einer Spule und einem Schaltelement, das beim Durchschalten den Strom durch die Spule freigibt. Dabei ist vorgesehen, daß ein erster Einschaltstoß mit verhältnismäßig hoher Stromstärke eingeleitet wird, anschließend wird, beispielsweise durch gezieltes Ein- und Ausschalten des Schaltelementes, ein getakteter Strom niedrigerer Stromstärke aufrechterhalten. Ziel des Einschaltstoßes hoher Stromstärke ist es, den sich auf die Polflächen zubewegenden Anker auch sicher einzufangen. Um den an den Polflächen ruhenden Anker in seiner angezogenen Stellung zu belassen, bedarf es dann lediglich des geringeren, getakteten Stromes.

Fig. 1 gibt den Stromverlauf wieder. Zu einem Zeitpunkt $t=0$ wird der Strom eingeschaltet und steigt, sich asymptotisch gegen einen Maximalwert nähernd, an. Gleichzeitig bewegt sich bedingt durch die Federbeaufschlagung des Gaswechselventils, der Anker auf die Polflächen zu, und aus dem mechanischen Aufbau heraus sind die Flugzeiten des Ankers bis zum Auftreffen auf die Polfläche mit hinreichender Reproduzierbarkeit vorherbestimmbar. Zum Zeitpunkt $t_0$ trifft der Anker auf die Polflächen auf, das Auftreffen ist aus dem Stromverlauf erkennbar, an dieser Stelle nimmt der Strom kurzzeitig ab, um dann anschließend wieder bis auf seinen Maximalwert $I_{ein}$ anzusteigen.

Der Stromverlauf, wie er sich ergeben würde, wenn der Anker nicht aufträte, ist durch die gestrichelten Linien dargestellt. Deutlich erkennbar ist, daß der kurzzeitige Abfall des Stromverlaufes dabei nicht stattfindet.

Erfindungsgemäß wird nun der Stromverlauf in einem Zeitintervall um den Zeitpunkt $t_0$ herum, beispielsweise in dem Bereich von $t_1$ bis $t_2$, überwacht. Fällt der Stromverlauf in diesem Zeitintervall ab, liegt in dem System die Information vor, daß der Anker auch tatsächlich auf die Polflächen aufgetroffen ist.

Die Überwachung kann beispielsweise durch Differenzierung des Stromverlaufes stattfinden. Das dadurch gewonnene Signal ist in Fig. 2 dargestellt. Fällt also in dem Zeitintervall zwischen $t_1$ und $t_2$ das differenzierte Signal auf einen negativen Wert ab, ist der Anker aufgetroffen.

Nicht zeichnerisch dargestellt ist die Vorrichtung zur Durchführung des Verfahrens, die eine den Stromverlauf überwachende Schaltung besitzt. Der in Fig. 1 dargestellte Stromverlauf wird differenziert, woraus das Signal gemäß Fig. 2 erhalten wird. Mit dem dargestellten Zeitpunkt $t_1$ wird ein Zeitfenster geöffnet, innerhalb dessen die Schaltung das Differenziersignal gemäß Fig. 2 erwartet. Ist bis zum Zeitpunkt $t_2$ das Differenziersignal nicht aufgetreten, wird die Startvorrichtung für das Gaswechselventil sofort angesteuert, da nunmehr die Überwachungsschaltung davon ausgeht, daß das Gaswechselventil nicht in seine Öffnungs- bzw. Schließstellung gelangt ist. Mit Ansteuerung der Startvorrichtung wird das Gaswechselventil erneut gestartet, so daß die Brennkraftmaschine ihren Betrieb fortsetzen kann.

Durch dieses erfindungsgemäße Verfahren geht somit maximal ein Arbeitstakt eines Zylinders verloren, die dadurch verursachte kurzzeitige Leistungsabnahme ist für den Betreiber der Brennkraftmaschine kaum merkbar. Sollte aufgrund äußerer Einflüsse trotz Auftreffens der Ankerplatte auf die Polflächen der Elektromagnete das Differenziersignal ausbleiben, ist das erneute Ansteuern der Startvorrichtung unschädlich für den weiteren Betrieb.

**Patentansprüche**

1. Verfahren zum Betreiben einer mit elektromagnetisch arbeitenden Haltevorrichtungen für Gaswechselventile und mit einer Startansteuerung für die Gaswechselventile ausgerüsteten Brennkraftmaschine, **dadurch gekennzeichnet,** daß
   a) in einem vorgegebenen Zeitintervall ($t_1$–$t_2$) nach Einschalten des Stromes für die elektromagnetischen Haltevorrichtungen der Stromverlauf überwacht wird,
   b) bei abfallendem Stromverlauf über zumindest einen Teilbereich des überwachten Zeitintervalls ein Signal erzeugt wird, das das Auftreffen des Ankers auf die Polflächen der elektromagnetisch arbeitenden Haltevorrichtung anzeigt, und
   c) bei Ausbleiben des Signals in dem Zeitintervall das Gaswechselventil erneut gestartet wird.

2. Verfahren nach Anspruch 2, **dadurch gekennzeichnet,** daß das Signal nur erzeugt wird, wenn der Abfall des Stromverlaufes einen vorgegebenen Steilheitswert überschritten hat.

3. Verfahren nach Anspruch 1 oder 2, **dadurch gekennzeichnet,** daß der Stromverlauf mindestens einmal differenziert wird zur Gewinnung des Signals bei abfallendem Stromverlauf.

4. Vorrichtung zur Durchführung des Verfahrens nach einem der Ansprüche 1 bis 3, mit einer

Brennkraftmaschine mit Gaswechselventilen, die gegen eine Federkraft beaufschlagt in ihren Öffnungs- und Schließstellungen durch erregte Elektromagnete gehalten werden, und die über eine Startvorrichtung aus ihrer Ruhelage in die Öffnungs- oder Schließstellung bewegt werden, **gekennzeichnet durch** eine den Stromverlauf des den Elektromagneten ansteuernden Stromes auswertende Schaltung mit einem Differenzierglied, an dessen Ausgang der differenzierte Stromverlauf erscheint, und einem Vergleichsglied, das den differenzierten Stromverlauf aufnimmt und ein Signal abgibt, wenn ein vorgebbarer, das Auftreffen des Ankers auf die Polflächen des Elektromagneten anzeigender Wert unter- bzw. überschritten wird, und mit einer Ansteuereinheit, die bei Ausbleiben des Signales die Startansteuerung aktiviert.

**Claims**

1. A method of operating an internal combustion engine furnished with electromagnetically operating holding devices for gas reversing valves and start control for the gas reversing valves, characterized in that
   a) the course of the current is monitored in a given interval ($t_1$-$t_2$) upon switch-on of the current for the electromagnetic holding devices,
   b) a signal indicating the striking of the armature on the pole faces of the electromagnetically operating holding device is generated if the course of the current drops at least across a partial range of the interval watched,
   c) the gas reversing valve is restarted if the signal fails to appear within the interval.

2. The method as claimed in claim 1, characterized in that the signal is not provided unless the drop in the course of the current has exceeded a given steepness value.

3. The method as claimed in claim 1 or 2, characterized in that the course of the current is differentiated at least once to obtain the signal as the course of the current drops.

4. An apparatus for carrying out the method as claimed in one of claims 1 to 3, comprising an internal combustion engine including gas reversing valves which are held by excited electromagnets in opening and closing positions against spring bias and moved by a starting device out of their inoperative position into the opening and closing positions, respectively, characterized by a circuit evaluating the course of the current which controls the electromagnet and comprising a differentiating member at the output of which appears the differentiated course of the current and a comparator member which receives the differentiated course of the current and emits a signal when a value to be preset and indicative of the striking of the armature on the pole faces of the electromagnet is failed to be reached or exceeded, and comprising a control unit which activates the start control in the absence of the signal.

**Revendications**

1. Procédé de commande d'un moteur à combustion interne équipé de dispositifs de retenue électromagnétiques pour des soupapes à gaz à mouvement alternativ et d'une commande de démarrage pour ces soupapes à gaz à deux voies, caractérisé en ce que:

a) dans un intervalle de temps prédéfini ($t_1$–$t_2$) après l'établissement du courant pour les dispositifs de retenue électromagnétiques, l'allure du courant est surveillée,

b) lorsque l'aillure du courant baisse surf une partie au moins de l'intervalle de temps surveillé, il est produit un signal qui indique l'application de l'arrmature sur les faces polaires du dispositif de retenue fonctionnant électromagnétiquement et

c) lorsque le signal n'est pas produit dans l'intervalle de temps, la soupape à gaz est de nouveau mise en marche.

2. Procédé selon la revendication 1, caractérisé en ce que le signal n'est produit que quand la baisse de l'allure du courant a dépassé une valeur de pente prédéfinie.

3. Procdédé selon la revendication 1 ou 2, caractérisé en ce que l'allure du courant est différentiée au moins une fois pour l'obtention du signal lorsque l'allure du courant baisse.

4. Dispositif pour l'exécution du procédé selon l'une quelconque des revendications 1 à 3, avec un moteur à combustion interne équipé de soupapes à gaz à mouvement alternatif qui sont retenues dans leurs positions d'ouverture et de fermeture par des électro-aimants excités contre la force antagoniste de ressorts, et qui sont placées dans la position d'ouverture ou de fermeture, à partir de leur position de repos, au moyen d'un dispositif de démarrage, caractérisé par un circuit qui évalue l'allure du courant d'excitation des électro-aimants, circuit qui comprend un élément différentiateur à la sortie duquel apparaît l'allure du courant différentiée et délivre un signal lorsqu'une valeur prédéfinissable indiquant l'application de l'armature sur les faces polaires de l'électro-aimant est dépassée vers le bas ou vers le haut, le circuit comprenant une unité de commande qui active la commande de démarrage en cas d'absence du signal.

FIG. 1

FIG. 2